# EUROPEAN PATENT APPLICATION

(11) **EP 3 471 222 A1**
(43) Date of publication of application: **17.04.2019**
(21) Application number: 16904596.0
(22) Date of filing: 08.06.2016
(51) Int. Cl.: H01S 5/0687, H01S 5/024

(54) **LASER LIGHT SOURCE DEVICE**

(71) Applicant: Mitsubishi Electric Corporation, Chiyoda-ku Tokyo 100-8310 (JP)
(72) Inventor: MURAMATSU, Shunsuke, Tokyo 1008310 (JP)
(74) Representative: Pfenning, Meinig & Partner mbB
(86) International application number: PCT/JP2016/067017
(87) International publication number: WO 2017/212561

(57) **Abstract**

Provided is a laser light source device stably operating, stably emitting laser light having a predetermined wavelength, and ensuring lower power consumption than that of the related art. The laser light source device includes a semiconductor laser element configured to emit laser light, a heat radiation part provided on one surface side of the semiconductor laser element, a heat conductive part having heat conductive characteristics, provided in contact with the one surface of the semiconductor laser element and the heat radiation part, configured to conduct heat generated in the semiconductor laser element to the heat radiation part, a wavelength measuring part configured to measure a wavelength of the laser light, and a heat conductive characteristic control part configured to change the heat conductive characteristics of the heat conductive part based on the wavelength of the laser light measured by the wavelength measuring device, and control the wavelength of the laser light to fall within a predetermined wavelength range.

## Description

### Technical Field

The present invention relates to a laser light source device, particularly to a technique to stably control a wavelength.

### Background Art

A wavelength of laser light emitted from a semiconductor laser element changes in accordance with a temperature of the semiconductor laser element. Accordingly, a laser light source device of the related art that uses the semiconductor laser element as a light source for video equipment is provided with a wavelength control unit to obtain a desired wavelength. The wavelength control unit includes, for example, a temperature control unit using a ThermoElectric Cooler (TEC) such as Peltier element and a wavelength measuring unit that measures a wavelength of laser light (see Patent Document 1 and Non Patent Document 1).

### Prior Art Documents

### Patent Documents

Patent Document 1: Japanese Patent Application Laid-Open No. 2012-124287

### Non-Patent Documents

Non-Patent Document 1: Shota Yamamoto, "Wavelength Stabilization System for Semiconductor Laser," Kochi University of Technology (March 2007), [Online] Internet (URL: http://www.kochi-tech.ac.jp/library/ron/2006/2006ele/1070347.pdf) searched on May 25th 2016

### Summary

### Problem to be Solved by the Invention

Temperature control using TEC requires a temperature sensor such as a thermocouple and a temperature measuring resistor to measure a temperature of a semiconductor laser element. However, when the temperature sensor falls off from the temperature measuring unit, or a breakdown of the temperature sensor per se occurs, a problem is caused that temperature control is inappropriately performed. Further, in a temperature control system using TEC, temperatures of TEC and a surrounding part thereof are required to change to a target temperature, a thermal capacity required for the temperature control becomes large and responsiveness in the wavelength control is low. Moreover, in a temperature control system using TEC, the power is being consumed throughout the temperature control, and a problem of large power consumption is further caused.

It is an object of the present invention to provide a laser light source device stably operating, stably emitting laser light having a predetermined wavelength, and ensuring lower power consumption than that of the related art.

### Means to Solve the Problem

According to an aspect of the present invention, a laser light source device includes a semiconductor laser element configured to emit laser light, a heat radiation part provided on a side of one surface of the semiconductor laser element, a heat conductive part having heat conductive characteristics, provided in contact with the one surface of the semiconductor laser element and the heat radiation part, configured to conduct heat generated in the semiconductor laser element to the heat radiation part, a wavelength measuring part configured to measure a wavelength of the laser light, and a heat conductive characteristic control part configured to change the heat conductive characteristics of the heat conductive part based on the wavelength of the laser light measured by the wavelength measuring part, and control the wavelength of the laser light to fall within a predetermined wavelength range.

### Effects of the Invention

A laser light source device stably operating, stably emitting laser light having a predetermined wavelength, and ensuring lower power consumption than those of the related art is provided.

Those and other objects, features, aspects and advantages of the present invention will become more apparent from the following detailed description of the present invention will become more apparent from the following detailed description of the present invention when taken in conjunction with the accompanying drawings..

### Brief Description of Drawings

[FIG. 1] A diagram illustrating a configuration of a laser light source device according to an embodiment.
[FIG. 2] A block diagram for the laser light source device according to the embodiment.
[FIG. 3] A diagram illustrating a processing circuit according to the embodiment.
[FIG. 4] A diagram illustrating a processing circuit according to the embodiment.
[FIG. 5] A diagram illustrating a state of a heat conductive part by stress control according to the embodiment.
[FIG. 6] A flowchart illustrating a wavelength control operation by heat conductive characteristic control according to the embodiment.
[FIG. 7] A flowchart illustrating a stress control operation according to the embodiment.

### Description of Embodiment

An embodiment of a laser light source device according to the present invention is described.

### (Configuration of Laser Light Source Device)

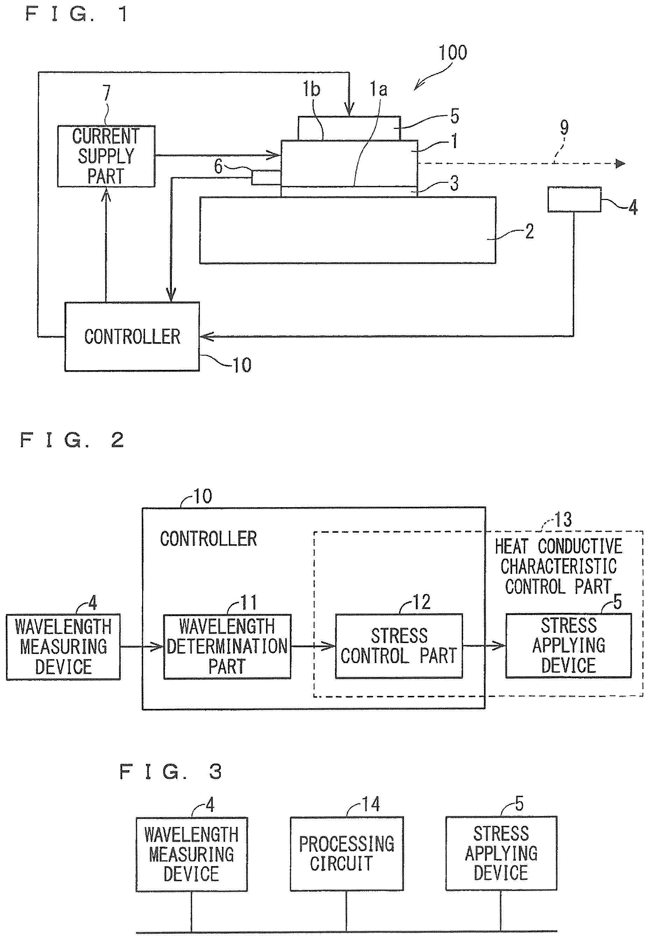

FIG. 1 is a diagram illustrating a configuration of a laser light source device 100 according to an embodiment. The laser light source device 100 includes a semiconductor laser element 1 that emits laser light and a heat radiation part 2 that is provided on a side of one surface 1a of the semiconductor laser element 1 and that radiates heat generated from the semiconductor laser element 1. The heat radiation part 2 includes, for example, a heat sink. The heat radiation part 2 may also include, for example, an air cooling fan and a cooling device such as a water-cooling mechanism (not shown). The laser light source device 100 of the present embodiment includes a cooling device in the heat radiation part 2.

In addition, the laser light source device 100 further includes a heat conductive part 3 that is in contact with both the one surface 1a of the semiconductor laser element 1 and the heat radiation part 2. The heat conductive part 3 is held between the one surface 1a and the heat radiation part 2. The heat conductive part 3 has high heat conductive characteristics and has a function to conduct heat generated in the semiconductor laser element 1 to the heat radiation part 2. The heat conductive part 3 includes, for example, a carbon fiber material. And, the heat conductive part 3 fixes the semiconductor laser element 1 on the heat radiation part 2. In addition, in the present embodiment, the heat conductive part 3 has elasticity.

The laser light source device 100 further includes a wavelength measuring device 4 that measures a wavelength of laser light 9 emitted by the semiconductor laser element 1. The wavelength measuring device 4 includes, for example, a spectroscope, a spectrum analyzer, and so forth.

The laser light source device 100 further includes a stress applying device 5 on a side of another surface 1b opposite to the one surface 1a of the semiconductor laser element 1. The stress applying device 5 applies stress to the heat conductive part 3 by pressing the semiconductor laser element 1 from the side of the other surface 1b toward the heat radiation part 2 while coming into contact with it. That is, the stress applying device 5 applies compressive stress in a holding direction between the semiconductor laser element 1 and the heat radiation part 2 to the heat conductive part 3. The stress applying device 5 represents a compressive stress applying device configured to apply stress to external objects by expansion or contraction of liquid or gas contained inside thereof, for example. An example of the compressive stress applying device includes a hydraulic cylinder and an air cylinder. The stress applying device 5 may include a compressive stress applying device having a screw mechanism capable of rotary driving and a compressive stress applying device having a spring mechanism. Meanwhile, in the present embodiment, the stress applying device 5 is provided on the side of the other surface 1b opposite to the one surface 1a of the semiconductor laser element 1, however, the stress applying device 5 may be provided such that a side surface of the semiconductor laser element 1 is supported therewith. In that case, the side surface the stress applying device 5 supports is a side surface except an emitting surface from which the laser light 9 is emitted and an end surface opposite to the emitting surface.

Further, the laser light source device 100 further includes a temperature sensor 6 that measures a temperature of the semiconductor laser element 1, a current supply part 7 that supplies a current to the semiconductor laser element 1, and a controller 10. The controller 10 controls the current supply part 7 to output the laser light 9 of intensity a user desires. And, heat generated in the semiconductor laser element 1 is conducted to heat radiation part 2 via the heat conductive part 3. The controller 10 controls an operation of the cooling device of the heat radiation part 2 such that the temperature of the semiconductor laser element 1 measured by the temperature sensor 6 falls within a specified temperature range. The temperature of the semiconductor laser element 1 is also controlled by a heat conductive characteristic control unit 13 to be described later, and the heat conductive characteristic control unit 13 performs wavelength control of the laser light 9 by changing the temperature of the semiconductor laser element 1 within the specified temperature range for the cooling device to perform temperature control. The details will be described later.

FIG. 2 is a block diagram of parts involved in the wavelength control by heat conductive characteristic control performed by the laser light source device 100. The laser light source device 100 includes a wavelength determination part 11 and a stress control part 12. In the present embodiment, the wavelength determination part 11 and the stress control part 12 are included in the controller 10. The heat conductive characteristic control unit 13 provided in the laser light source device 100 of the present embodiment includes the stress applying device 5 and stress control part 12 described above. The wavelength determination part 11 determines whether a measurement wavelength of the laser light 9 measured by the wavelength measuring device 4 falls within a predetermined wavelength range, or determines whether the measurement wavelength of the laser light 9 falls within a wavelength range in which the measurement wavelength is controllable by a subsequently described heat conductive characteristic control operation. The stress control part 12 calculates, based on a difference between the measurement wavelength measured by the wavelength measuring device 4 and a target wavelength the user desires, magnitude of stress to be applied to the heat conductive part 3 by the stress applying device 5, then, sets the calculated stress for the stress applying device 5. The stress applying device 5 applies the set stress to the semiconductor laser element 1. As a result, thermal resistance in an interface between the heat conductive part 3 and semiconductor laser element 1 or thermal resistance in an interface between the heat conductive part 3 and the heat radiation part 2 changes, and this leads to a change of temperature of the semiconductor laser element 1. The change of temperature changes the wavelength of the laser light 9 emitted by the semiconductor laser element 1. The stress applying device 5 and stress control part 12 described above are an example of the heat conductive characteristic control unit 13, and the heat conductive characteristic control unit 13 changes heat conductive characteristics of the heat conductive part 3 based on a wavelength of the laser light 9 measured by the wavelength measuring device 4, thereby controlling the wavelength of the laser light 9 to fall within the predetermined wavelength range. The details of the wavelength control operation by the heat conductive characteristic control will be described later.

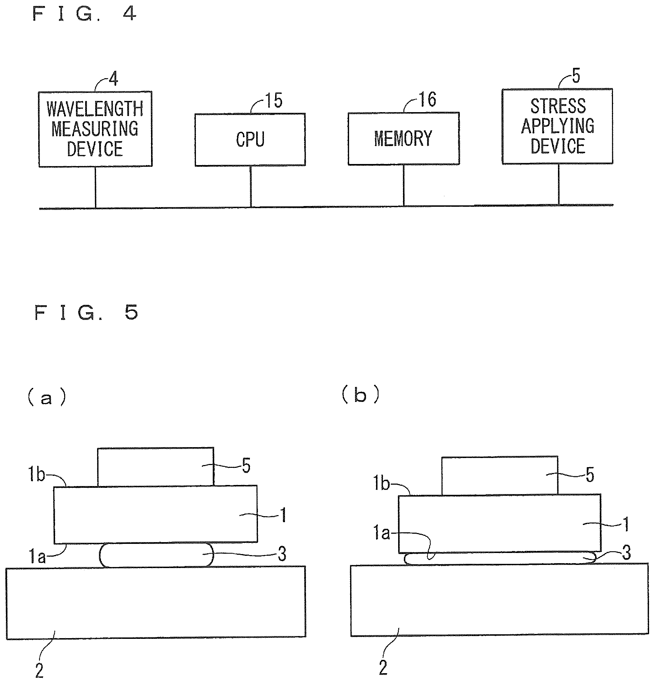

FIG. 3 illustrates a processing circuit 14 provided in the laser light source device 100. The processing circuit 14 realizes each of the function of the wavelength determination part 11 and the function of the stress control part 12. That is, the laser light source device 100 includes the processing circuit 14 in which the wavelength determination part 11 determines the measurement wavelength, the stress control part 12 calculates, based on the measurement wavelength, stress to be applied to the heat conductive part 3 by the stress applying device 5, and the calculated stress is set for the stress applying device 5. In a case where the processing circuit 14 is dedicated hardware, the processing circuit 14 includes, for example, a programmed processor and a parallel programed processor. In the processing circuit 14, the operation of the wavelength determination part 11 and the operation of the stress control part 12 may be realized respectively by providing a plurality of dedicated hardware corresponding to the respective functions, or may be realized in an integrated manner by providing a single dedicated hardware. Further, the processing circuit 14 includes, as illustrated in FIG. 4, a CPU 15 and a memory 16 connected to each other and may have a function of causing the CPU 15 to execute a program to be stored in the memory 16. In that case, each function of the wavelength determination part 11 and the stress control part 12 is written as program and the programs are stored in the memory 16 as software or firmware. The processing circuit 14 reads out the programs stored in the memory 16 and causes the CPU 15 to execute thereof. Each function of the wavelength determination part 11 and the stress control part 12 is thus realized. Further, the memory 16 includes, for example, a volatile or nonvolatile semiconductor memory such as RAM and a flash memory. Further, in the laser light source device 100, the function of the wavelength determination part 11 and the function of the stress control part 12 each may be realized by the dedicated hardware in part, and may be realized by the software or the firmware in part.

### (Wavelength Control Operation by Heat Conductive Characteristic Control)

In the laser light source device 100 of the present embodiment, the heat conductive characteristic control unit 13 changes heat conductive characteristics of the heat conductive part 3 based on the wavelength of the laser light 9 measured by the wavelength measuring device 4, thereby controlling the wavelength of the laser light 9 to fall within the predetermined wavelength range. The heat conductive characteristics of the heat conductive part 3, which the heat conductive characteristic control unit 13 changes, is the thermal resistance in an interface between the one surface 1a of the semiconductor laser element 1 and the heat conductive part 3 or the thermal resistance in the interface between the heat conductive part 3 and the heat radiation part 2.

Description is made of a case where the stress applying device 5 applies the compressive stress in the direction from the other surface 1b side toward the heat radiation part 2. The heat conductive part 3 is subjected to compressive stress to be elastically deformed, and is thinly spread between the semiconductor laser element 1 and the heat radiation part 2 by Poisson's effect. FIG. 5(a) illustrates a state of a heat conductive part 3 before the stress applying device 5 applies stress. FIG. 5(b) illustrates a state of the heat conductive part 3 after the stress applying device 5 applies stress. In the interface between the one surface 1a of the semiconductor laser element 1 and the heat conductive part 3, a contact area therebetween after the stress applying device 5 applies the stress is increased. Similarly, in the interface between the heat conductive part 3 and the heat radiation part 2, a contact area therebetween is increased. As a result, the thermal resistance in the interface between the one surface 1a of the semiconductor laser element 1 and the heat conductive part 3 or the thermal resistance in the interface between the heat conductive part 3 and the heat radiation part 2 is reduced. That is, exhaust heat efficiency from the semiconductor laser element 1 to the heat radiation part 2 via the heat conductive part 3 is enhanced, leading to a reduction of the temperature of the semiconductor laser element 1. As a result, an oscillation wavelength of the semiconductor laser element 1, namely, the wavelength of the laser light 9 to be emitted is changed. In the present embodiment, the wavelength of the laser light 9 shifts to the short-wavelength side.

Meanwhile, when the stress applying device 5 reduces the compressive stress applied to the semiconductor laser element 1, the heat conductive part 3 is elastically deformed, its thickness is large, and the contact area is reduced. That is, the heat conductive part 3 returns from the state illustrated in FIG. 5(b) to the state illustrated in FIG. 5(a). Accordingly, in the interface between the one surface 1a of the semiconductor laser element 1 and the heat conductive part 3, the contact area therebetween is reduced. Similarly, in the interface between the heat conductive part 3 and the heat radiation part 2, a contact area therebetween is increased. As a result, the thermal resistance in the interface between the one surface 1a of the semiconductor laser element 1 and the heat conductive part 3 or the thermal resistance in the interface between the heat conductive part 3 and the heat radiation part 2 is increased. That is, the exhaust heat efficiency from the semiconductor laser element 1 to the heat radiation part 2 via the heat conductive part 3 is lowered, leading to an increase of the temperature of the semiconductor laser element 1. As a result, the oscillation wavelength of the semiconductor laser element 1, namely, the wavelength of the laser light 9 to be emitted is changed. In the present embodiment, the wavelength of the laser light 9 shifts to the long-wavelength side.

As described above, the change of the compressive stress applied by the stress applying device 5 changes the thermal resistance. And the change of the thermal resistance changes the temperature of the semiconductor laser element 1. Further, the change of temperature of the semiconductor laser element 1 changes the wavelength of the laser light 9. The heat conductive characteristic control unit 13 including the stress applying device 5 controls the wavelength of the laser light 9 with high responsiveness.

### (Wavelength Control Method by Heat Conductive Characteristic Control)

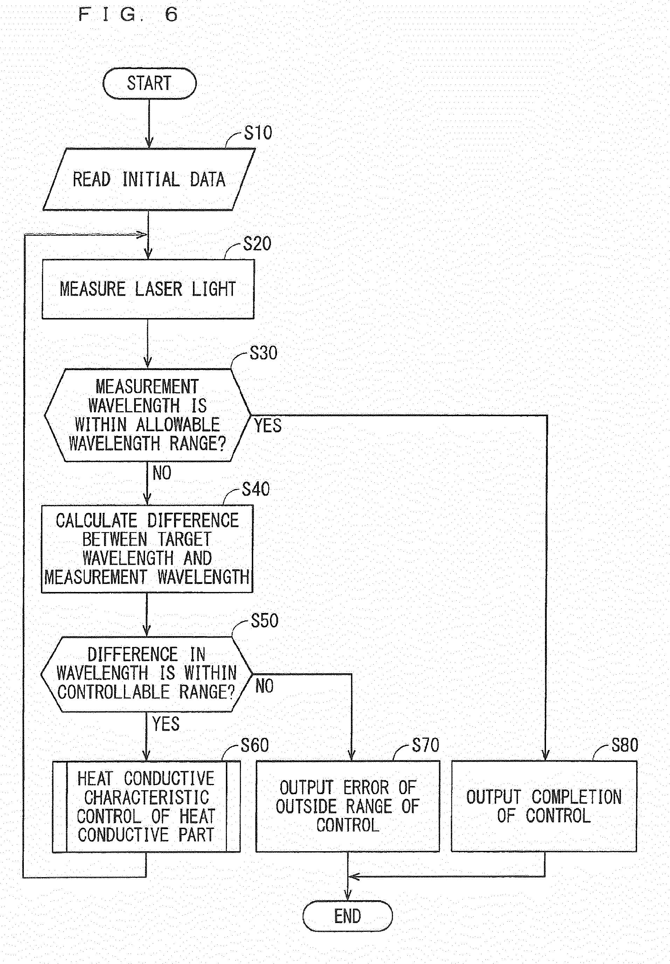

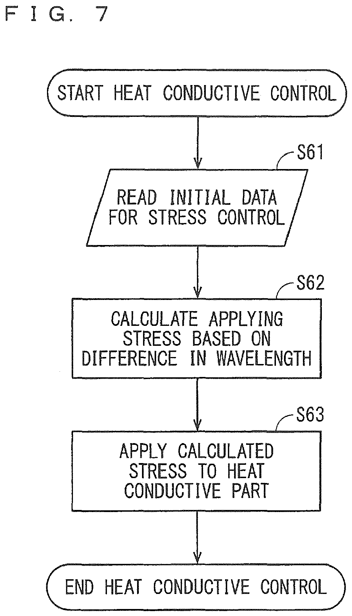

FIGs. 6 and 7 are flowcharts illustrating a wavelength control method by heat conductive characteristic control by the laser light source device 100. The description is made of the wavelength control method by the laser light source device 100 by reference to the block diagram of FIG. 2 and the flowcharts of FIGs. 6 and 7.

First, the controller 10 of the laser light source device 100 reads initial data (step S10). The initial data includes a target wavelength of the laser light 9 the user desires, an allowable wavelength range corresponding to the target wavelength, and a controllable range included in the heat conductive characteristic control unit 13. As examples of the target wavelength and the allowable wavelength range, values input by the user are read. As an example of the controllable range, values previously stored in the memory may be read. For example, a program with the controllable range previously written eliminates a reading operation in the step S10. And, the controller 10 controls the current supply part 7 to control a current supplied to the semiconductor laser element 1 such that the semiconductor laser element 1 emits the laser light 9 of desired intensity The laser light 9 is emitted from the semiconductor laser element 1 thereby.

The wavelength measuring device 4 measures the wavelength of the laser light 9 emitted from the semiconductor laser element 1 (step S20). The measurement wavelength measured in the step S20 is input into the wavelength determination part 11. The wavelength determination part 11 determines whether the measurement wavelength is within the allowable wavelength range corresponding to the target wavelength obtained in the step S10 (step S30). When the measurement wavelength is within the allowable wavelength range, that is, a determination result is YES in the step S30, the controller 10 completes the control by outputting completion of control (step S80).

When the measurement wavelength is outside the allowable wavelength range, that is, the determination result is NO in the step S30, the wavelength determination part 11 calculates a difference in wavelength between the target wavelength obtained in the step S10 and the measurement wavelength (step S40). The wavelength determination part 11 determines whether the measurement wavelength is within the controllable wavelength range obtained in the step S10 (step S50). That is, the present embodiment determines whether the difference in wavelength is controllable by changing of the compressive stress applied by the stress applying device 5. When the difference in wavelength is outside the controllable range, that is, NO in the step S50, the controller 10 completes the control by outputting error of outside range of control (step S70).

When the difference in wavelength is within the controllable range, that is, YES in the step S50, the heat conductive characteristic control unit 13 performs the heat conductive characteristic control of heat conductive part 3 (step S60). The description is made of the heat conductive characteristic control by reference to FIG. 7. First, the stress control part 12 reads initial data for stress control (step S61). The initial data for the stress control represents data including a relationship between magnitude of stress applied to the semiconductor laser element 1 by the stress applying device 5 and magnitude of a wavelength change of the laser light 9 caused thereby, examples thereof include a predetermined table and a predetermined calculation formula. And, for example, the memory 16 stores such data and the stress control part 12 reads the data in the step S61. The stress control part 12 calculates the stress applied to the semiconductor laser element 1 based on the difference in wavelength calculated in the step S40 and the data obtained in the step S61 (step S62). The stress control part 12 sets the stress calculated in the step S62 for the stress applying device 5 and the stress applying device 5 applies the compressive stress to the semiconductor laser element 1 with the set stress (step S63). As described above, the heat conductive part 3 is subjected to the compressive stress applied by the stress applying device 5 to be elastically deformed, and then the thermal resistance in the interface between the one surface 1a of the semiconductor laser element 1 and the heat conductive part 3 or the thermal resistance in the interface between the heat conductive part 3 and the heat radiation part 2 is changed. As a result, the temperature of the semiconductor laser element 1 changes, and the wavelength of the laser light 9 accordingly changes. After the step S 63, the laser light source device 100 returns to the step S20 again, and controls the wavelength to coincide with the target by performing the series of processes. That is, the laser light source device 100 repeats the above-described feedback control. Further, the step S61 may be omitted from the second time in the heat conductive characteristic control.

### (Effect)

To summarize the above, the laser light source device 100 of the present embodiment includes the semiconductor laser element 1 that emits the laser light 9, the heat radiation part 2 provided on the side of one surface 1a of the semiconductor laser element, a heat conductive part 3 having heat conductive characteristics, provided in contact with the one surface 1a of the semiconductor laser element 1 and the heat radiation part 2, configured to conduct heat generated in the semiconductor laser element 1 to the heat radiation part 2, a wavelength measuring device 4 configured to measure a wavelength of the laser light 9, a heat conductive characteristic control unit 13 configured to change the heat conductive characteristics of the heat conductive part 3 based on the wavelength of the laser light 9 measured by the wavelength measuring device 4, and control the wavelength of the laser light 9 to fall within a predetermined wavelength range. The configuration described above ensures that the laser light source device 100 stably operates and stably emits the laser light 9 of the wavelength the user desires. Further, the laser light source device 100 ensures lower power consumption than the laser light source device of related art. Further, the laser light source device 100 performs, not the wavelength control based on a temperature, but the wavelength control based on the wavelength of the laser light 9 to be actually emitted, therefore, the laser light source device 100 ensures reduction in generation frequency of abnormality in temperature control and moreover in wavelength control in the semiconductor laser element 1 attributed to the failed temperature measurement.

Further, the heat conductive part 3 of the laser light source device 100 of the present embodiment is held between the semiconductor laser element 1 and the heat radiation part 2. The heat conductive characteristic control unit 13 includes the stress applying device 5 that applies the stress in the holding direction between the semiconductor laser element 1 and the heat radiation part 2 to the heat conductive part 3 and the stress control part 12 that controls the magnitude of stress applied by the stress applying device 5 based on the wavelength of the laser light 9 measured by the wavelength measuring device 4. Heat conductive characteristics of the heat conductive part 3, which the heat conductive characteristic control unit 13 change, is thermal resistance in the interface between the one surface 1a of the semiconductor laser element 1 and the heat conductive part 3 or thermal resistance in the interface between the heat conductive part 3 and the heat radiation part 2. The configuration described above ensures that the laser light source device 100 changes the above described thermal resistance in accordance with the changes of the compressive stress applied to the heat conductive part 3 by the stress applying device 5, and ensures quicker responsiveness of wavelength control than the laser light source device of the related art. Further, the laser light source device 100 ensures, except during a time that the stress applying device 5 changes the stress, the reduction in power consumption for the wave length control of the laser light 9, therefore, achieves power saving.

Further, the stress applying device 5 of the laser light source device 100 of the present embodiment is provided on the side of the other surface 1b opposite to the one surface 1a of the semiconductor laser element 1 and applies the stress by pressing the semiconductor laser element 1 to the heat radiation part 2 via the heat conductive part 3 from the side of the other surface 1b. The configuration described above ensures that the stress applying device 5 of the laser light source device 100 readily applies the stress to the heat conductive part 3. As illustrated in FIG. 1 in particular, when the semiconductor laser element 1 of an end-face emission type is mounted on the heat radiation part 2, the laser light source device 100 is capable of applying the stress to the heat conductive part 3 without blocking the emitting surface of the laser light 9.

Further, the heat conductive part 3 of the laser light source device 100 of the present embodiment includes carbon fibers. The configuration described above ensures that the laser light source device 100 efficiently conduct the heat generated in the semiconductor laser element 1 to the heat radiation part 2.

Further, the heat conductive part 3 of the laser light source device 100 of the present embodiment is formed of an elastic body that is elastically deformed in accordance with the stress. The configuration described above ensures that the laser light source device 100 reversibly and swiftly changes the contact area between the one surface 1a of the semiconductor laser element 1 and the heat conductive part 3, consequently the thermal resistance of the interface between the one surface 1a of the semiconductor laser element 1 and the heat conductive part 3 is reversibly and swiftly changed, Further, the laser light source device 100, similarly, reversibly and swiftly changes the contact area between the heat conductive part 3 and the heat radiation part 2, consequently, the thermal resistance of the interface between the heat conductive part 3 and the heat radiation part 2 is reversibly and swiftly changed.

The embodiment of the present invention can be appropriately modified or omitted without departing from the scope of the invention.

While the invention has been described in detail, the foregoing description is in all aspects illustrative and not restrictive. It is understood that numerous other modifications and variations can be devised without departing from the scope of the invention.

### Explanation of Reference Signs

1 semiconductor laser element, 2 one surface, 1b other surface, 2 heat radiation part, 3 heat conductive part, 4 wavelength measuring device, 5 stress applying device, 9 laser light, 11 wavelength determination part, 12 stress control part, 13 heat conductive characteristic control device, 100 laser light source device

## Claims

1. A laser light source device, comprising:
a semiconductor laser element (1) configured to emit laser light (9);
a heat radiation part (2) provided on a side of one surface (1a) of the semiconductor laser element (1);
a heat conductive part (3) having heat conductive characteristics, provided in contact with the one surface (1a) of the semiconductor laser element (1) and the heat radiation part (2), configured to conduct heat generated in the semiconductor laser element (1) to the heat radiation part (2);
a wavelength measuring part (4) configured to measure a wavelength of the laser light (9); and
a heat conductive characteristic control part (13) configured to change the heat conductive characteristics of the heat conductive part (3) based on the wavelength of the laser light (9) measured by the wavelength measuring part (4), and control the wavelength of the laser light (9) to fall within a predetermined wavelength range.

2. The laser light source device according to claim 1,
wherein the heat conductive part (3) is held between the semiconductor laser element (1) and the heat radiation part (2),
the heat conductive characteristic control part (13) includes
a stress applying part (5) configured to apply stress in a holding direction between the semiconductor laser element (1) and the heat radiation part (2) to the heat conductive part (3), and
a stress control part (12) configured to control the stress applied by the stress applying part (5) based on the wavelength of the laser light (9) measured by the wavelength measuring part (4), and
wherein the heat conductive characteristics of the heat conductive part (3), which the heat conductive characteristic control part (13) changes, is thermal resistance in an interface between the one surface (1a) of the semiconductor laser element (1) and the heat conductive part (3) or thermal resistance in an interface between the heat conductive part (3) and the heat radiation part (2).

3. The laser light source device according to claim 2, wherein
the stress applying part (5) is provided on a side of another surface (1b) opposite to the one surface (1a) of the semiconductor laser element (1), and is configured to apply the stress by pressing the semiconductor laser element (1) to the heat radiation part (2) via the heat conductive part (3) from the side of the other surface (1b).

4. The laser light source device according to any one of claims 1 to 3, wherein
the heat conductive part (3) includes carbon fibers.

5. The laser light source device according to any one of claims 1 to 4, wherein
the heat conductive part (3) is formed of an elastic body that is elastically deformed in accordance with the stress.
